# EUROPEAN PATENT APPLICATION

(11) **EP 0 551 887 A2**
(43) Date of publication of application: **21.07.1993**
(21) Application number: 93100424.6
(22) Date of filing: 13.01.1993
(51) Int. Cl.: H01L 31/153

(54) **Opto-electronic integrated circuit**

(30) Priority: 13.01.1992 US 821389
(71) Applicant: EASTMAN KODAK COMPANY, Rochester, New York 14650-2201 (US)
(72) Inventor: Lawrence, David Joseph, c/o Eastman Kodak Comp., Rochester, New York 14650-2201 (US); Hill, Clifford Otis, c/o Eastman Kodak Comp., Rochester, New York 14650-2201 (US); Kahen, Keith Brian, c/o Eastman Kodak Comp., Rochester, New York 14650-2201 (US); Peterson, David L., c/o Eastman Kodak Comp., Rochester, New York 14650-2201 (US); Smith, Frank Thomas John, c/o Eastman Kodak Comp., Rochester, New York 14650-2201 (US)
(74) Representative: Wagner, Karl H., Dipl.-Ing.

(57) **Abstract**

An opto-electronic integrated circuit is formed of a body of a semi-insulating semiconductor material having a plurality of recesses therein extending from a surface thereof and at least one region of n-type conductivity in the body at the surface. A region of a highly conductive semiconductor material of one conductivity type partially fills each recess and extends along a side of the recess to the surface of the body. A separate opto-electronic semiconductor device fills the remaining portion of each recess and extends to the surface of the body. A separate field-effect transistor is in each of the regions. Conductive strips extend over and are electrically insulated from the surface of the body and electrically connect the field-effect transistors and the opto-electronic devices to form a desired circuit. The recesses may extend completely through the body and field-effect transistors may also be provided on the other surface of the body and electrically connected to the opto-electronic devices. The semiconductor regions in the recesses serve as a contact for one side of each of the opto-electronic devices to provide for vertical flow of current through the opto-electronic devices.

## Description

### Field of the Invention

The present invention relates to an opto-electronic integrated circuit, and, more particularly, to an integrated circuit which includes both opto-electronic devices, such as laser diodes, light emitting diodes and photodiodes, as well as electronic devices, such as bipolar transistors and field-effect transistors.

### Background of the Invention

For modern communications systems and the like, it is desirable to have integrated circuits which include both opto-electronic devices, such as laser diodes (LD), light emitting diodes (LED), photodiodes and the like, and electronic devices, such as field-effect transistors (FET), bipolar transistors and the like. A problem in forming both opto-electronic devices and electronic devices in a single common substrate for an integrated circuit is that the two types of devices require different structures and different types of materials to achieve desired electrical and optical characteristics. For example, LDs and LEDs are typically formed by layers of various group III-V semiconductor materials on a highly conductive substrate of gallium arsenide (GaAs) or similar material having a low dislocation density. On the other hand, FETs are typically fabricated in semi-insulating GaAs or like material, and the dislocation density is less critical.

U.S. Patent No. 4,532,694 (Robert M. Kolbas), issued August 6, 1985, and entitled "Method of Fabrication Emitter/Detector-in-a-Well for the Integration of Electronic and Optoelectronic Components" discloses an integrated circuit which includes a substrate of a semi-insulating GaAs having a recess in one surface. Layers of various suitable group III-V semiconductor materials are deposited in succession in the recess to form an opto-electronic device and a FET is formed on the surface of the substrate adjacent to the recess. However, a problem with the integrated circuit shown in this patent is that the opto-electronic device is of a structure having a vertical p-n junction which provides for lateral current flow. This is more difficult to make and does not have the same opto-electronic characteristics of a standard opto-electronic device which has a transverse horizontal p-n junction for vertical current flow.

An article entitled "GaAs/GaAlAs Selective MOCVD Epitaxy and Planar Ion-Implantation Technique for Complex Integrated Optoelectronic Circuit Applications" by M.E. Kim et al, published in IEEE Electron Device Letters, Vol. EDL-5, No. 8, August 1984, pages 306-309 discloses an opto-electronic integrated circuit including a laser diode formed in a groove in a substrate of semi-insulating gallium arsenide and a FET formed in a n-type conductivity well in the substrate. The laser diode has a horizontal p-n junction. However, the laser diode does not fill the groove so that the contacts to the laser diode are in the groove and spaced from the surface of the substrate. Thus, the integrated circuit is non-planar. This requires that the conductive strips connecting the FET to the laser diode must extend over relative large steps to reach the contacts of the laser diode. Forming the conductive strips over such steps is difficult and could lead to breaks in the strips at the sharp corners of the steps. Also, the series resistance of the laser diode will be higher, making it less efficient, and the current density across the active layer of the laser diode will be less uniform.

Therefore, it would be desirable to have an opto-electronic integrated circuit which provides the proper material for each of the opto-electronic devices and the electronic devices, and which provides opto-electronic devices having transverse horizontal p-n junctions. Also, the surface of the opto-electronic device should be planar with the surface of the substrate to allow for ease of electrically connecting the opto-electronic device to the electronic devices of the integrated circuit. In addition, in order to increase the number of electronic devices which can be included in the integrated circuit, it would be desirable to have an opto-electronic integrated circuit with electronic devices on both surfaces of a substrate.

### Summary of the Invention

The present invention is directed to an opto-electronic integrated circuit in which an opto-electronic device is formed in a recess in one surface of a body of a semi-insulating material and an electronic device is formed on the surface of the body. The opto-electronic device comprises a region of a highly conductive material of a first conductivity type in a portion of the recess and extending to the surface of the body and an opto-electronic body filling the remaining portion of the recess and extending to the surface of the semiconductor body. The opto-electronic body contains at least two regions, one of the first conductivity type and the other of a second conductivity type opposite that of the first conductivity type. An electronic device may be on the surface of the semiconductor body and electrically connected to the opto-electronic device.

One form of the opto-electronic integrated circuit comprises a semiconductor body of a semi-insulating material having a pair of opposed surfaces. A recess is in the semiconductor body and extends from one of the surfaces of the body. The recess has a pair of spaced side walls. A region of a semiconductor material of a first conductivity type is in a portion of the recess and extends along one of the side walls of the recess to the one surface of the semiconductor body. An opto-electronic device is in the recess and fills the remaining portion of the recess so as to extend to the one surface of the semiconductor body. The opto-electronic device has at least two layers, one of which is of the first conductivity type and the other is of a second conductivity type opposite that of the first conductivity type. The opto-electronic integrated circuit may also include an electronic device on the one surface of the semiconductor body and electrically connected to the opto-electronic device.

A second form of the opto-electronic integrated circuit is similar to the one form except that the recess extends completely through the semiconductor body from the one surface to the other surface. The region of the semiconductor material extends along the other surface of the semiconductor body and has a portion extending along a wall of the recess to the one surface of the semiconductor body. The opto-electronic device fills the remaining portion of the recess and extends to the one surface of the semiconductor body. The opto-electronic integrated circuit may include electronic devices on both surfaces of the semiconductor body and electrically connected to the opto-electronic device.

The invention will be better understood from the following more detailed description taken with the accompanying drawings.

### Brief Description of the Drawings

FIG. 1 is a cross-sectional view of one form of an opto-electronic integrated circuit in accordance with the present invention;
FIGS. 2-6 are cross-sectional views illustrating the steps of a method of making the opto-electronic integrated circuit shown in FIG. 1; and
FIG. 7 is a cross-sectional view of another form of the opto-electronic integrated circuit in accordance with the present invention.

The drawings are not necessarily drawn to scale.

### Detailed Description

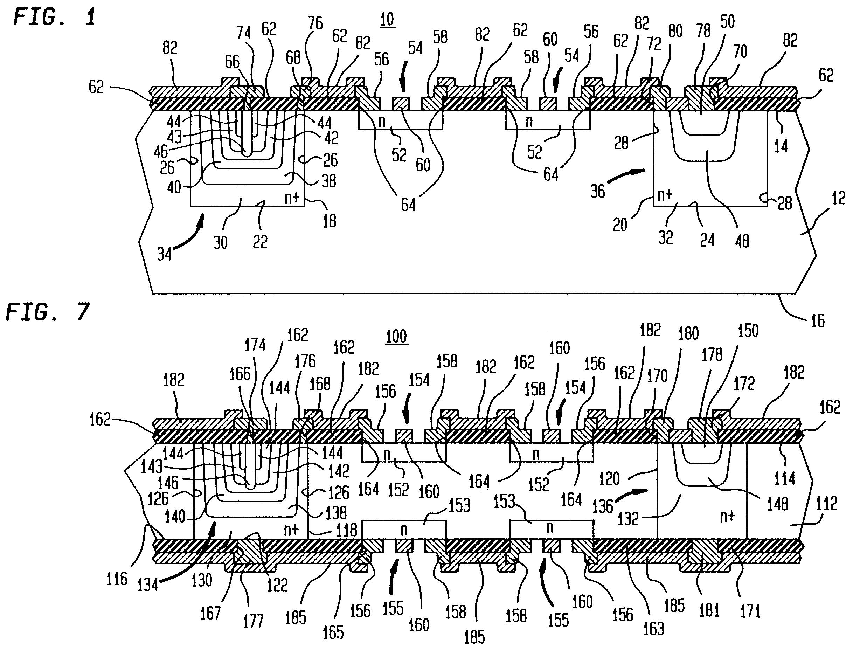

Referring now to FIG. 1, there is shown a cross-sectional view of an opto-electronic integrated circuit 10 in accordance with the present invention. The integrated circuit 10 comprises a semiconductor body 12 of a insulating or semi-insulating semiconductor material, such as semi-insulating gallium arsenide (GaAs), having a pair of opposed surfaces 14 and 16. The semiconductor body 12 has a pair of spaced apart recesses 18 and 20 in the surface 14 thereof. Each of the recesses 18 and 20 has a bottom 22 and 24, respectively, and spaced side walls 26 and 28, respectively. The recesses 18 and 20 can be of any desired cross-sectional shape, such as round, rectangular, etc., and is considered to have the side walls. Each of the recesses 18 and 20 is partially filled with a highly conductive semiconductor material 30 and 32 respectively of either conductivity type, shown as n+ type conductivity, but could be p+ type conductivity depending on the opto-electronic device to be formed in the particular recess. The semiconductor material 30 and 32 may be of gallium arsenide. The semiconductor material 30 and 32 extends along the bottom 22 and 24 of the respective recess 18 and 20 and along at least one of the side walls 26 and 28, respectively, to the surface 14 of the semiconductor body 12. The remaining portion of each of the recesses 18 and 20 is filled with layers of a semiconductor material, which will be described in detail later, to form the desired opto-electronic devices 34 and 36, respectively. As shown, the opto-electronic device 34 is a laser diode shown as laser diode 34 whereas the opto-electronic device 36 is a photodetector shown as photodetector 36.

The laser diode 34 comprises a first clad layer 38 of n-type conductivity AlGaAs on the semiconductor material 30, a thin active layer 40 on the first clad layer 38, a second clad layer 42 of p-type conductivity AlGaAs on the active layer 40, a current blocking layer 43 of n-type conductivity AlGaAs on the second clad layer 42 and a capping layer 44 of n-type conductivity GaAs on the current blocking layer 43. The active layer 40 may be of GaAs of either conductivity type or, more preferably, of a quantum well structure. A region 46 of p+ type conductivity extends through the capping layer 44, the current blocking layer 43 and into the second clad layer 42. The capping layer 44 extends to and is preferably coplanar with the surface 14 of the body 12. However, the laser diode 34 can be of any well known construction.

The recess 18 containing the laser diode 34 has at least one side extending to one side edge (not shown) of the semiconductor body 12. This allows at least one end of the active layer 40 of the laser diode 34 to be at the side edge of the semiconductor body 12 to permit light to be emitted therefrom. However, the recess 18 can be completely within the semiconductor body 12 and provided with reflectors at least one end of the active layer 40 to reflect the light from the laser diode 34 therefrom substantially perpendicular to the surface 14 of the semiconductor body 12. The reflectors can be in the form of slanted mirrors or suitable reflecting gratings.

The photodetector 36 comprises a thick layer 48 of n-type conductivity semiconductor material, such as GaAs or AlGaAs, on the semiconductor material 32. A thin layer 50 of p+ type conductivity semiconductor material, such as GaAs or AlGaAs, is on the layer 48 to form a p-n junction therewith. The layer 50 extends to and is preferably coplanar with the surface 14 of the body 12. However, the photodetector 36 can be of any well known construction including the same construction as the laser diode 34.

Regions 52, which are shown as of an n-type conductivity semiconductor material, such as GaAs, are in the semiconductor body 12 along the surface 14 and are separated from each other and from recesses 18 and 20 by portions of semiconductor body 12. The regions 52 are shown as being located between the recesses 18 and 20, but can be located anywhere along the surface 14 around the recesses 18 and 20. The regions 52 are typically much shallower than the recesses 18 and 20. Formed on each of the region 52 is a field effect transistor (FET) 54. Each FET 54 comprises a pair of spaced apart electrical contacts 56 and 58 on the region 52. The contacts 56 and 58 are of a conductive material, such as a metal, which makes ohmic contact with the semiconductor material of the region 52 to form the source and drain of the FET 54. Between the contacts 56 and 58 and on the region 52 is a gate contact 60. The gate contact 60 is of a conductive material which forms a Schottky barrier junction with the material of the region 52 to form the gate of the FET 54.

On the surface 14 of the semiconductor body 12 is a layer 62 of an insulating material, such as silicon dioxide or silicon nitride. The insulating layer 62 has openings (apertures) 64 therethrough over the regions 52 in which the contacts 56 and 58 and the gate 60 of each FET 54 is formed. The insulating layer 62 has openings (apertures) 66 and 68 therethrough over the p+ type conductor region 46 of the laser diode 34 and the conductive semiconductor material 30 in the recess 18 respectively. Also, the insulating layer 62 has openings (apertures) 70 and 72 therethrough over the p+ type layer 50 of the photodetector 36 and the conductive semiconductor material 32 in the recess 20, respectively.

Conductive contacts 74 and 76 are in the openings 66 and 68 in the insulating layer 62 and on the conductor region 46 and the semiconductor material 30, respectively. Conductive contacts 78 and 80 are in the openings 70 and 72 in the insulating layer 62 and on the p+ type layer 50 and the semiconductor material 32, respectively. The contacts 74, 76, 78 and 80 are of a suitable material, such as a metal or a multi-layered structure of different metals, which makes ohmic contact with their respective regions, and layers. The laser diode 34, photodetector 36 and FETs 54 are electrically connected in a desired circuit by a pattern of conductive metal strips 82 which extend over the insulating layer 62 between the various contacts 74 and 76 of the laser diode 34, the contacts 78 and 80 of the photodetector 36 and the contacts 56 and 58 of the FETs.

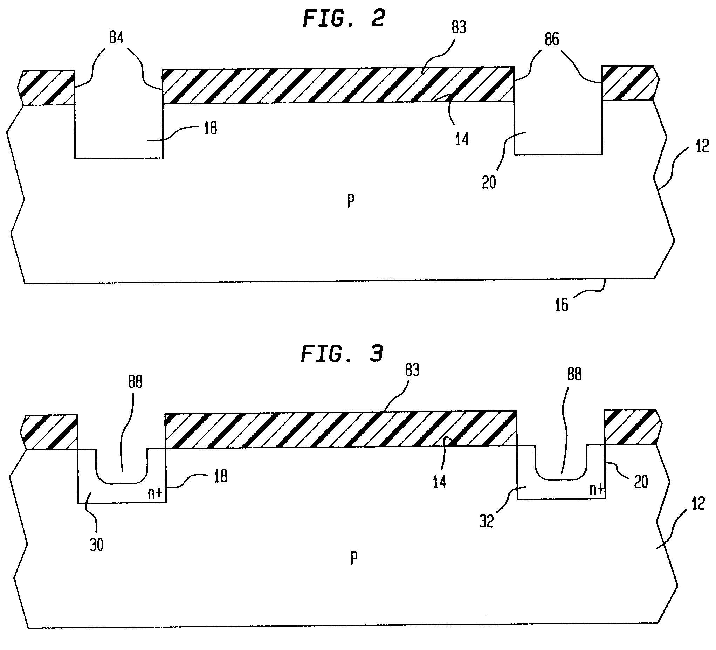

Referring to FIG. 2, there is shown a cross-sectional view of the semiconductor body 12 formed by initial steps of a method for making the opto-electronic integrated circuit 10 of FIG. 1 in accordance with the present invention. A masking layer 83 is coated over the surface 14 of the semiconductor body 12. The masking layer 83 is provided with openings (apertures) 84 and 86 therethrough using standard photolithographic techniques over areas of the surface 14 where the recesses 18 and 20 are to be formed. These areas of the surface 14 and portions of semiconductor body 12 therebetween are then removed with a suitable etchant to form the recesses 18 and 20.

Referring now to FIG. 3, there is shown a cross-sectional view of the semiconductor body 12 after the next steps of the method for making the integrated circuit 10. The recesses 18 and 20 are now partially filled with the n+ type semiconductor materials 30 and 32, respectively. This can be achieved by any well known epitaxial process suitable for the particular material used, such as liquid phase epitaxy or vapor phase epitaxy. It is the nature of these epitaxial processes that the material is coated over the surfaces of the recesses 18 and 20 in a layer and is built up leaving a recess 88 in the deposited layer, as shown in FIG. 3. Alternatively, the recesses 18 and 20 can be completely filled or overfilled with the semiconductor material 30 and 32 which is then lapped to make the surface of the materials 30 and 32 planar with the surface 14 of the body 12. Then using masking, lithography and etching, the materials 30 and 32 can be etched to form the recesses 88 therein of any desired width and depth and location in the materials. 30 and 32.

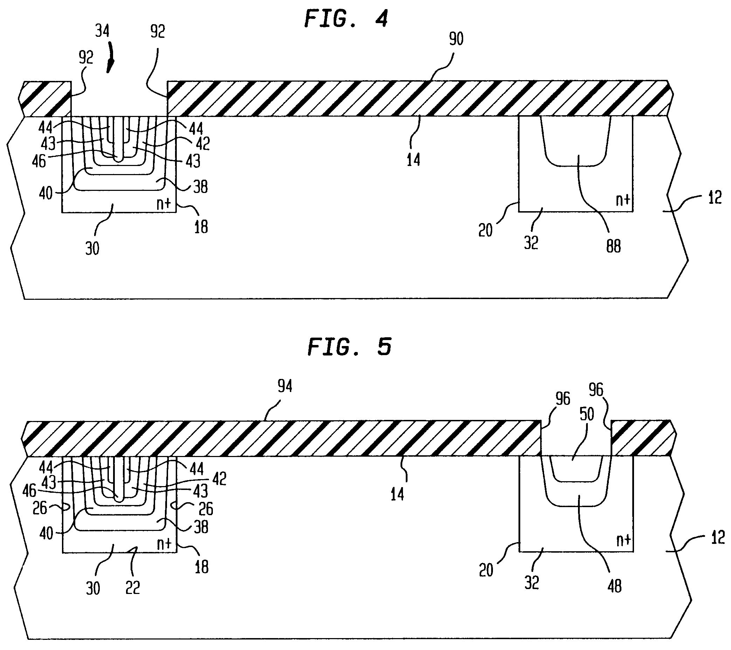

Referring now to FIG. 4, there is shown a cross-sectional view of the semiconductor body 12 after the next steps of the method for making the integrated circuit 10. The initial masking layer 83 is removed and another masking layer 90 is formed on the surface 14. The masking layer 90 is provided with an opening (aperture) 92, using standard photolithographic techniques, over one of the recesses 18 and 20. As shown in FIG. 4, the opening 92 is over the recess 18. The laser diode 34 is then formed in the recess 88 in the semiconductor material 30 by depositing in succession the first clad layer 38, the active layer 40, the second clad layer 42, the current blocking layer 43 and the capping layer 44. These layers may be deposited by any well known epitaxial deposition process, such as liquid phase epitaxy or vapor phase epitaxy. The conductive region 46 is then formed through the layers 44 and 43 and into the layer 42 by diffusion of a p-type conductivity impurity, such as zinc, therethrough.

Referring now to FIG. 5, there is shown a cross-sectional view of the semiconductor body 12 after the next steps of the method for making the integrated circuit 10. The masking layer 90 is removed and another masking layer 94 is coated on the surface 14. The masking layer 94 is provided with an opening (aperture) 96 therethrough over the recess 20. The photodetector 36 is then formed in the recess 88 in the semiconductor material 32. This is achieved by depositing in succession the n-type conductivity layer 48 and the p+ type conductivity layer 50 using any well known epitaxial deposition technique. If the photodetector 36 is formed of the same structure as the laser diode 34, they can both be formed as the same time. Even if they are of different structures, the photodetector 36 can be formed prior or after forming the laser diode 34.

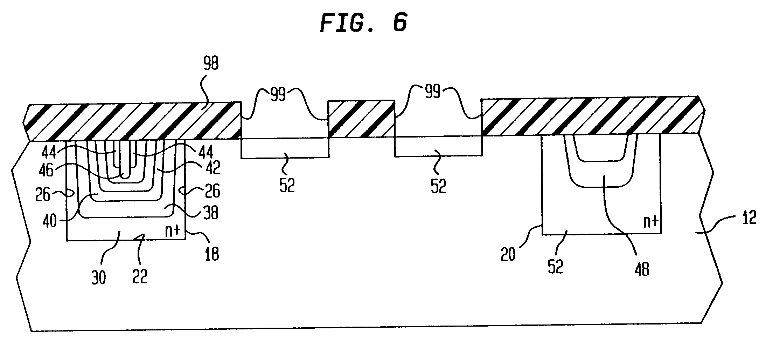

Referring now to FIG. 6, there is shown a cross-sectional view of the semiconductor body 12 after the next step of the method of making the integrated circuit 10 of FIG. 1. The masking layer 94 has been removed an another masking layer 98 is formed on the surface 14. The masking layer 98 has apertures 99 therethrough which expose separated portions of the surface 14 of semiconductor body 12. Separated n-type regions 52 are formed in the semiconductor body 12 by ion implantation or deposition and drive or other suitable technique.

The masking layer 98 is then removed, and, as is shown in FIG. 1, an insulating layer 62 is deposited on the surface 14 using chemical vapor deposition or other well known techniques. The insulating layer 62 is then provided with the openings 64 over the regions 52, the openings 66 and 68 over the laser diode 34 and the openings 70 and 72 over the photodetector. This is done using standard photolithographic techniques and etching.

Electrical contacts 56 and 58 to FETs 54, electrical contacts 74 and 76 to the laser diode 34, and electrical contacts 78 and 80 to the photodetector 34 are then formed. These electrical contacts can be formed of the such conductive materials as a metal or multi-layer structures of different metals. For this purpose, the conductive material for the contacts is coated over the insulating layer 62 and in the openings 64, 66, 68, 70 and 72. The conductive layers are then defined by photolithographic techniques and etching or by lift-off techniques to form the various contacts. Gate electrical contacts 60 are then formed on the regions 52. Since the gate electrical contacts 60 form a Schottky barrier junction with the regions 52, they are generally of a different material than the source and drain contacts 56 and 58. However, the gate contacts 60 are also formed by applying a layer of the conductive material which is to form the gate contacts 60 and defining the layer to form the gate contacts 60. The metal strips 82 which interconnect the contacts are then formed. This is achieved by depositing a layer of the metal over the insulating layer 62 and the contacts and then defining the metal layer to form the strips 82. Multiple levels of interconnect metalization, like the strips 82, can be used to produce more complex interconnection patterns. Such multiple levels are usually insulated from one another by additional dielectric layers having windows therethrough where connections between the levels are made.

Referring now to FIG. 7, there is shown a cross-sectional view of another opto-electronic integrated circuit 100 in accordance with the present invention. Portions of circuit 100 which are similar to circuit 10 of FIG. 1 have the same reference designation with the "1" added in front thereof. The opto-electronic integrated circuit 100, like the integrated circuit 10 shown in FIG. 1, comprises a semiconductor body 112 of a semi-insulating semiconductor material, such as GaAs, having opposed surfaces 114 and 116. A pair of spaced recesses 118 and 120 are in the semiconductor body 112, but unlike the recesses 18 and 20 in the semiconductor body 12, they extend completely through the semiconductor body 112 between the surfaces 114 and 116. In each of the recesses 118 and 120 is a body of a highly conductive n-type conductivity (n+ type) semiconductor material 130 and 132, respectively. The semiconductor bodies 130 and 132 partially fill their respective recesses 118 and 120. They extend across and are planar with the surface 116 of the semiconductor body 112 and extend along the side walls of the recesses 118 and 120 to the semiconductor body surface 114.

As in the opto-electronic integrated circuit 10, filling the remaining portions of the recesses 118 and 120 are a laser diode 134 and a photodetector 136, respectively. The laser diode 134 comprises a first clad layer 138 of n-type conductivity, an active layer 140, a second clad layer 142 of p-type conductivity, a current blocking layer 143 of n-type conductivity, a capping layer 144 of n-type conductivity and a p-type conductivity conductive region 146 extending through the capping layer 144 and the current blocking layer 143 into the second clad layer 142. The photodetector 136 comprises an n-type conductivity layer 148 and a p-type conductivity layer 150.

In the surface 114 of the semiconductor body 112 are regions 152 of n-type conductivity. Also, in the surface 116 of the semiconductor body 112 are regions 153 of n-type conductivity. In each of the regions 152 and 153 are FETs 155. Each of the FETs 155 comprises a pair of spaced contacts 156 and 158 in ohmic contact with each respective region 152 and 153 and forming the source and drain contacts of the FETs. Between the contacts 156 and 158 are gates 160 which form a Schottky barrier junction with the respective regions 152 and 153.

A layer 162 of an insulating material is on the surface 114 of the semiconductor body, and a layer 163 of an insulating material is on the surface 116. The insulating layer 162 has openings 164 therethrough over the regions 152, openings 166 and 168 therethrough over the recess 118 and openings 170 and 172 therethrough over the recess 120. The insulating layer 163 has openings 165 therethrough over the regions 153 and openings 167 and 171 therethrough over the recesses 118 and 120, respectively.

The openings 164 and 165 expose the contacts 156, 158 and 160 of the FETs 154 and 155. In the openings 166 and 168 are contacts 174 and 176 to the laser diode 134 and in the openings 170 and 172 are contacts 178 and 180 to the photodetector 136. In the openings 167 and 171 are contacts 177 and 181 which make ohmic contact with the semiconductor regions 130 and 132 respectively. A pattern of conductive strips 182 are on the insulating layer 162 and electrically connect the various contacts of the FETs 154, laser diode 134 and photodetector 136 in a desired circuit. A pattern of conductive strips 185 are on the insulating layer 163 and electrically connect the contacts of the FETs 155, the laser diode 134, and photodetector 136 to form a desired circuit.

The opto-electronic integrated circuit 100 is made in the same manner as the opto-electronic integrated circuit 10 previously described with regard to FIGs. 1 - 6. However, before or after the laser diode 134 and photodetector 136 are formed in the recesses which extend partially through the semiconductor body, the semiconductor body is thinned down from its back surface, such as by grinding, lapping or polishing, until the bottoms of the recesses are reached. The surface 116 of the semiconductor body 112 is then coplanar with the semiconductor material 130 and 132 in the recesses 118 and 120. The insulating layers 162 and 163 are then deposited on the surfaces 114 and 116, respectively, and provided with the various openings therethrough. The contacts and conductive strips are then formed as described above with regard to the opto-electronic integrated circuit 10.

Thus, there is provided by the present invention an opto-electronic integrated circuit containing both opto-electronic devices, such as laser diodes and photodetectors, on the same semiconductor body as electronic devices, such as FETs, with the opto-electronic devices and electronic devices being electrically connected to form a desired circuit. The opto-electronic devices are formed in recesses in the semi-insulating semiconductor body of materials which are highly suitable for providing opto-electronic devices having desired characteristics. However, the electronic devices are formed in materials which are different from those which form the opto-electronic devices and which provide the electronic devices with desired characteristics. Furthermore, although the opto-electronic devices have all their contacts on the same surface of the semiconductor body and coplanar with the surface of the semiconductor body so as to permit ease of connecting them to the electronic devices, the opto-electronic devices are constructed so that the current flows vertically through the devices and across the junctions therein. This further provides opto-electronic devices having good operating characteristics as compared to the integrated circuit disclosed in each of the U.S. Patent No. 4,532,694 and the article of M.E. Kim et al which are discussed in the Background of the Invention and which teaches the use of lateral devices and non-planar devices respectively. This vertical flow of the current is provided by the semiconductor material which is in each of the recesses. The semiconductor material is electrically connected to the one side of the opto-electronic device which is adjacent the bottom of the recess and extends along at least one side wall of the recess to the surface of the semiconductor body so as to provide a contact at the semiconductor body surface. In addition, the opto-electronic integrated circuit of the present invention can be formed with electronic devices on both surfaces of the semiconductor body which are electrically connected together and to the opto-electronic devices by extending the recesses completely through the semiconductor body. This allows the number of devices which can be included in the circuit to be increased to permit the forming of more complicated and larger circuits.

It is to be appreciated and understood that the specific embodiments of the invention are merely illustrative of the general principles of the invention. Various modifications may be made consistent with the principles set forth. For example, the particular construction and materials of the laser diode and the photodetector can be changed to any desired construction and materials. Also, the integrated circuit can include any number of the opto-electronic devices and electronic devices which are necessary or desired for a particular circuit.

The invention may be summarized as providing an opto-electronic integrated circuit comprising:
a body of a semi-insulating semiconductor material having a pair of opposed surfaces;
a recess in the body;
a first region of a highly conductive semiconductor material of one conductivity type in a portion of the recess; and
an opto-electronic device in the recess and filling the remaining portion of the recess.

Preferred embodiments of the invention are disclosed in the claims and also the dependent claims, which should be read as depending not only on the specified claims, but on any other claim and combination thereof. The same is true for the following summary of the invention:

### The invention may be summarized as follows:

1. An opto-electronic integrated circuit comprising:
   a body of a semi-insulating semiconductor material having a pair of opposed surfaces;
   a recess in the body extending from one of the surfaces, the recess having a pair of spaced side walls;
   a first region of a highly conductive semiconductor material of one conductivity type in a portion of the recess and having a portion extending along one of the side walls to the one surface of the substrate; and
   an opto-electronic device in the recess and filling the remaining portion of the recess so as to extend to the one surface of the substrate, the opto-electronic device having at least two layers, the lower layer being of the same conductivity type as the semiconductor material of the first region, and the other layer being of a second conductivity type opposite the first conductivity type and extending to the one surface;
   the semiconductor material region acting as a contact for one side of the opto-electronic device to provide for vertical flow of current through the opto-electronic device.
2. The integrated circuit of 1 further comprising an electrical contact on the semiconductor material region at the surface of the body and a separate electrical contact on the opto-electronic device at the surface of the body.
3. The integrated circuit of 2 further comprising a second region of n-type conductivity in the body at the surface and spaced from the recess, a pair of spaced contacts on the second region and in ohmic contact therewith and a gate contact on the second region between the spaced contacts and forming a Schottky barrier junction with the second region, the contacts forming a field-effect transistor in the second region.
4. The integrated circuit of 3 further comprising a strip of conductive material over and insulated from the surface of the body and electrically connecting at least one of the contacts of the field-effect transistor with at least one of the contacts of the opto-electronic device in the recess.
5. The integrated circuit of 4 further comprising a layer of an insulating material on the surface of the body and having openings therethrough through which the contacts extend, and the strip of conductive material is on the insulating material layer.
6. The integrated circuit of 2 in which the opto-electronic device comprises a first layer of the same conductivity type as the first region on the first region, a second active layer on the first layer, a third layer of the opposite conductivity type on the active layer, and a capping layer on the third layer.
7. The integrated circuit of 6 in which the opto-electronic device further comprises a third region of the opposite conductivity type extending through the capping layer to the third layer and the contact is on the third region.
8. The integrated circuit of 5 in which the opto-electronic device comprises a first layer of the same conductivity type as the semiconductor material of the first region on the first region, and a second layer of the opposite conductivity type on the first layer and coplanar with the surface of the body, and the contact of the opto-electronic device is on the second layer.
9. The integrated circuit of 1 in which the recess extends completely through the body from the one surface to the other surface, the first region of semiconductor material extends across the recess at the other surface and is coplanar with the other surface, and extends along a side of the recess to the one surface.
10. The integrated circuit of 9 further comprising at least one separate second region of n-type conductivity in the body at each of the surfaces thereof and spaced from the recess, a separate pair of spaced contacts on each of the second regions and in ohmic contact therewith and a separate gate contact on each of the second regions between the spaced contacts and forming a Schottky barrier junction with the second region, the contacts forming a field-effect transistor in each of the second regions.
11. The integrated circuit of 10 further comprising a separate strip of conductive material over and insulated from each of the surfaces of the body, each of the strips electrically connecting at least one of the contacts of the field-effect transistor on its respective surface with at least one of the contacts of the opto-electronic device in the recess.
12. The integrated circuit of 11 further comprising a separate layer of insulating material on each surface of the body and having openings therethrough through which the contacts extend and the conductive strips are on the insulating layers.
13. An opto-electronic integrated circuit comprising:
   a body of semi-insulating semiconductor material having first and second opposed surfaces;
   a plurality of spaced recesses in the body extending from the first surface;
   a first region of a highly conductive semiconductor material of one conductivity type partially filling each of the recesses and extending along a side of the recesses to the first surface;
   an opto-electronic device in each of the recesses, the opto-electronic devices filling the remaining portion of the recesses and extending to the first surface;
   each of the semiconductor first regions serving as a contact for one side of the opto-electronic device in its respective recess to provide for vertical flow of current through the opto-electronic devices;
   at least one second region of n-type conductivity in the body at the first surface and spaced from the recesses;
   a field-effect transistor in the second region; and
   connecting means for electrically connecting the field-effect transistor and the opto-electronic devices so as to form a desired circuit.
14. The integrated circuit of 13 further comprising a separate contact on the semiconductor material first region in each of the recesses at the first surface of the body, and a separate contact on the opto-electronic device in each recesses at the first surface.
15. The integrated circuit of 14 in which the field-effect transistor comprises a pair of spaced contacts on the second region and in ohmic contact therewith and a gate contact on the second region between the spaced contacts and forming a Schottky barrier junction with the second region.
16. The integrated circuit of 15 in which the means connecting the field-effect transistor and the opto-electronic devices comprises at least one strip of conductive material over and insulated from the first surface of the body and connected to the contacts of the field-effect transistor and the opto-electronic devices.
17. The integrated circuit of 16 further comprising a layer of insulating material on the first surface of the body and having openings therethrough through which the contacts extend and the conductive strips are on the insulating layer.
18. The integrated circuit of 17 in which the semiconductor material first region in each recess extends across the bottom of the recess and along at least one side of the recess to the first surface of the body, and the layer of the opto-electronic device which is directly on the first region is of the same conductivity type as the first region.
19. The integrated circuit of 18 in which at least one of the opto-electronic devices comprises a first layer of the same conductivity type as the semiconductor material first region on the first region, a second active layer on the first layer, a third layer of the opposite conductivity type on the active layer, a capping layer on the third layer and planar with the first surface of the body, and a third region of the opposite conductivity type extending through the capping layer to the third layer.
20. The integrated circuit of 19 in which the contact of the one opto-electronic device is on the region of the opposite conductivity type.
21. The integrated circuit of 18 in which at least one of the opto-electronic devices comprises a first layer of the same conductivity type as the semiconductor material first region on the first region and a second layer of the opposite conductivity type on the first layer and coplanar with the surface of the body and the contact of the opto-electronic device is on the second layer.
22. The integrated circuit of 13 in which the recesses extend completely through the body from the first surface to the second surface, the first region of semiconductor material in each of the recesses extends along the second surface, is coplanar with the second surface and extends along a side of the recesses to the first surface, at least one second region of n-type conductivity is in the body at each of the surfaces, a separate field-effect transistor is in each of the second regions, and means on each of the surfaces for electrically connecting the field-effect transistors and the opto-electronic devices so as to form a desired circuit.
23. The integrated circuit of 22 in which each of the field-effect transistors comprises a pair of spaced contacts on each of the second regions and in ohmic contact therewith and a gate contact on each second region between the pair of contacts and forming a Schottky barrier junction with the second region.
25. The integrated circuit of 24 in which the means electrically connecting the field-effect transistors and the opto-electronic devices comprises separate conductive strips extending over and insulated from each of the body surfaces.

## Claims

1. An opto-electronic integrated circuit comprising:
a body of a semi-insulating semiconductor material having a pair of opposed surfaces;
a recess in the body extending from one of the surfaces, the recess having a pair of spaced side walls;
a first region of a highly conductive semiconductor material of one conductivity type in a portion of the recess and having a portion extending along one of the side walls to the one surface of the substrate; and
an opto-electronic device in the recess and filling the remaining portion of the recess so as to extend to the one surface of the substrate, the opto-electronic device having at least two layers, the lower layer being of the same conductivity type as the semiconductor material of the first region, and the other layer being of a second conductivity type opposite the first conductivity type and extending to the one surface;
the semiconductor material region acting as a contact for one side of the opto-electronic device to provide for vertical flow of current through the opto-electronic device.

2. The integrated circuit of claim 1 further comprising an electrical contact on the semiconductor material region at the surface of the body and a separate electrical contact on the opto-electronic device at the surface of the body.

3. The integrated circuit of claim 2 further comprising a second region of n-type conductivity in the body at the surface and spaced from the recess, a pair of spaced contacts on the second region and in ohmic contact therewith and a gate contact on the second region between the spaced contacts and forming a Schottky barrier junction with the second region, the contacts forming a field-effect transistor in the second region.

4. The integrated circuit of claim 3 further comprising a strip of conductive material over and insulated from the surface of the body and electrically connecting at least one of the contacts of the field-effect transistor with at least one of the contacts of the opto-electronic device in the recess.

5. The integrated circuit of claim 4 further comprising a layer of an insulating material on the surface of the body and having openings therethrough through which the contacts extend, and the strip of conductive material is on the insulating material layer.

6. The integrated circuit of claim 2 in which the opto-electronic device comprises a first layer of the same conductivity type as the first region on the first region, a second active layer on the first layer, a third layer of the opposite conductivity type on the active layer, and a capping layer on the third layer.

7. An opto-electronic integrated circuit comprising:
a body of semi-insulating semiconductor material having first and second opposed surfaces;
a plurality of spaced recesses in the body extending from the first surface;
a first region of a highly conductive semiconductor material of one conductivity type partially filling each of the recesses and extending along a side of the recesses to the first surface;
an opto-electronic device in each of the recesses, the opto-electronic devices filling the remaining portion of the recesses and extending to the first surface;
each of the semiconductor first regions serving as a contact for one side of the opto-electronic device in its respective recess to provide for vertical flow of current through the opto-electronic devices;
at least one second region of n-type conductivity in the body at the first surface and spaced from the recesses;
a field-effect transistor in the second region; and
connecting means for electrically connecting the field-effect transistor and the opto-electronic devices so as to form a desired circuit.

8. The integrated circuit of claim 7 further comprising a separate contact on the semiconductor material first region in each of the recesses at the first surface of the body, and a separate contact on the opto-electronic device in each recesses at the first surface.

9. The integrated circuit of claim 8 further comprising a layer of insulating material on the first surface of the body and having openings therethrough through which the contacts extend and the conductive strips are on the insulating layer.

10. The integrated circuit of claim 9 in which the semiconductor material first region in each recess extends across the bottom of the recess and along at least one side of the recess to the first surface of the body, and the layer of the opto-electronic device which is directly on the first region is of the same conductivity type as the first region.
